# EUROPEAN PATENT APPLICATION

(11) **EP 1 113 573 A1**
(43) Date of publication of application: **04.07.2001**
(21) Application number: 00311638.1
(22) Date of filing: 22.12.2000
(51) Int. Cl.: H03D 7/16

(54) **Tuner IC and receiving apparatus employing the same**

(30) Priority: 27.12.1999 JP 36953299
(71) Applicant: SONY CORPORATION, Tokyo 141 (JP)
(72) Inventor: Okanobu, Taiwa, Shinagawa-ku, Tokyo 141 (JP)
(74) Representative: DeVile, Jonathan Mark

(57) **Abstract**

A reception IC comprising a received-signal-selecting circuit (15) for selecting one of a plurality of received signals with reception bands different from each other, a frequency dividing circuit (42,43) for dividing the frequency of an oscillation signal (S41) supplied thereto and outputting a plurality of divided-frequency signals (SHA,SHB,SLA,SLB) having frequencies different from each other, a divided-frequency-signal-selecting circuit (44A,44B) for selecting one of the divided-frequency signals output by the frequency dividing circuit (42,43) as a local-oscillation signal, and a mixer circuit (31A,31B) for being input the local-oscillation signal output by the divided-frequency-signal-selecting circuit (44A,44B) and the received signal selected by the received-signal-selecting circuit (15), converting the frequency of the received signal and outputting the received signal with the converted frequency as an intermediate-frequency signal (SIFA,SIFB), wherein the received-signal-selecting circuit (15) selects one of the received signals for a selected reception band, the divided-frequency-signal-selecting circuit (44A,44B) selects one of the divided-frequency signals for the selected reception band, and by changing the frequency of the local oscillation signal for each selected reception band, the frequency of the received signal is changed.

## Description

### BACKGROUND OF THE INVENTION

The present invention relates to a reception IC and a receiving apparatus employing the reception IC.

As a digital audio broadcasting standard, DAB specifications are adopted in Europe whereas ISDB-T specifications are embraced in Japan. The DAB specifications are a digital audio broadcasting standard conforming to Eureka 147 specifications.

The ISDB-T specifications are listed as follows:
Transmission band width: 432 kHz (for a narrow-band ISDB-T standard)
Modulation method: OFDM
Multiplexing method: MPEG2

In accordance with the above specifications, digital data including audio digital data of a plurality of channels is broadcasted at the same time. In the case of the narrow-band ISDB-T standard, the use of the contemporary VHF television broadcasting band in the digital broadcasting is planned.

On the other hand, an analog receiver capable of receiving an audio signal of the VHF television broadcasting band in addition to signals of the AM and FM broadcasting is also put in the market. Moreover, the reception circuit of the analog receiver is implemented by an IC. Thus, for the ISDB-T standard, it is possible to realize an IC receiver.

However, the bands of the VHF television broadcasting are given as follows:
Low band (1 to 3 channels): 90 MHz to 108 MHz
High band (4 to 12 channels): 170 MHz to 222 MHz

Thus, for an intermediate frequency of 10.7 MHz, the ranges of the local oscillation frequency are given as follows:
Low band: 100.7 MHz to 118.7 MHz
High band: 180.7 MHz to 232.7 MHz

Therefore, a local oscillation circuit employed in a receiver for receiving an audio signal of the VHF television broadcasting must be capable of varying the local oscillation frequency over a considerably wide range.

In order to satisfy the above requirement, the local oscillation frequency is switched from a value for reception of a low-band broadcast to a value for reception of a high-band broadcast and vice versa.

The following techniques are conceivable as a method for switching the local oscillation frequency:
1: A technique to switch a coil and a variable-capacitance diode, which are used for oscillation in a local oscillation circuit, from components for reception of a low-band broadcast to those for reception of a high-band broadcast and vice versa.
2: A technique to change a local oscillation circuit for reception of a low-band broadcast to a local oscillation circuit for reception of a high-band broadcast and vice versa.

In the case of either technique, nevertheless, the variable-capacitance diodes, the coils and a switch device are required, inevitably increasing the number of external components attached to the IC. A large number of such external components entails an increase in receiver cost and serves as a disturbance to reduction of the size of the receiver.

In addition, in the case of the first technique described above, the switch device is connected to the oscillation circuit, unavoidably lowering the Q value of the oscillation circuit. As a result, the oscillation circuit exhibits poor characteristics as evidenced by, among others, the fact that it becomes difficult to make the oscillation circuit to oscillate, the number of phase noises increases, the number of pulling phenomena increases and the magnitude of a consumed current rises.

The same problem is also inevitably raised in a reception IC for digital audio broadcasting that makes use of a VHF television broadcasting band.

Particular and preferred aspects of the present invention are set out in the accompanying independent and dependent claims. Features of the dependent claims may be combined with features of the independent claims as appropriate, and in combinations other than those explicitly set out in the claims.

According to one aspect of the present invention, there is provided a reception IC including a received-signal-selecting circuit for selecting one of a plurality of received signals with reception bands different from each other, a frequency dividing circuit for dividing the frequency of an oscillation signal supplied thereto and outputting a plurality of divided-frequency signals having frequencies different from each other, a divided-frequency-signal-selecting circuit for selecting one of the divided-frequency signals output by the frequency dividing circuit as a local-oscillation signal, and a mixer circuit for being inputted the local-oscillation signal output by the divided-frequency-signal-selecting circuit and the received signal selected by the received-signal-selecting circuit, converting the frequency of the received signal and outputting the received signal with the converted frequency as an intermediate-frequency signal, wherein the received-signal-selecting circuit selects one of the received signals for a selected reception band, the divided-frequency-signal-selecting circuit selects one of the divided-frequency signals for the selected reception band, and by changing the frequency of the local oscillation signal for each selected reception band, the frequency of the received signal is changed.

Thus, the reception frequency of a received signal can be changed without switching an oscillation circuit from a variable-capacity diode and a coil to others to change the oscillation frequency for the reception band.

### BRIEF DESCRIPTION OF THE DRAWINGS

The invention will now be described by way of example with reference to the accompanying drawings, throughout which like parts are referred to by like references, and in which:
Fig. 1 is a system diagram showing an embodiment of the present invention;
Fig. 2 is a connection diagram showing a portion of the embodiment of the present invention;
Fig. 3 is a connection diagram showing the continuation of Fig. 2;
Fig. 4 is a system diagram showing another embodiment of the present invention;
Fig. 5 is a connection diagram showing a portion of the other embodiment of the present invention;
Fig. 6 is a connection diagram showing the continuation of Fig. 5;
Fig. 7 is a system diagram showing a further embodiment of the present invention; and
Fig. 8 is a system diagram showing a still further embodiment of the present invention.

### DETAILED DESCRIPTION OF THE PREFERRED EMBODIMENTS

### Receiver ---Part I

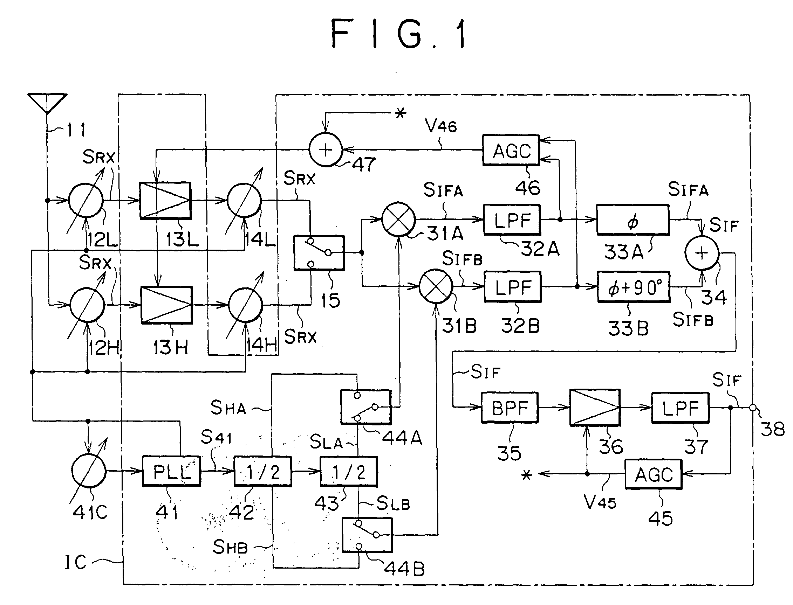

Fig. 1 is a diagram showing a typical receiver adopting the super-heterodyne system to conform to the narrow-band ISDB-T standard as provided by an embodiment of the present invention. This receiver includes switch circuits 15, 44A and 44B for switching the reception band. In accordance with control executed by a system controller, which is not shown in the figure, the switch circuits 15 to 44B are connected in a state of connection for receiving a low-band broadcast as shown in the figure. When receiving a high-band broadcast, however, the switch circuits 15 to 44B are connected in a state of connection opposite to the state shown in the figure. Circuits enclosed by a dashed line are implemented as a single-chip IC.

Next, configurations and operations for receiving low-band and high-band broadcasts are explained.

### Reception of low-band broadcasts

An antenna 11 receives an ISDB-T broadcasted wave and the received signal is supplied to antenna tuning circuits 12L and 12H, which each adopt an electronic tuning technique. The antenna tuning circuit 12L fetches a received signal SRX having a desired frequency in the low band. The received signal SRX is then supplied to mixer circuits 31A and 31B through signal lines by way of an AGC variable-gain amplifier 13L, an inter-stage tuning circuit 14L adopting the electronic tuning technique and the switch circuit 15.

A PLL circuit 41 generates an oscillation signal S41 with a frequency varied in the range of 362 MHz to 434 MHz according to the reception frequency. The oscillation signal S41 is supplied to a frequency dividing circuit 42 for multiplying the frequency of the oscillation signal S41 by 1/2. To be more specific, the frequency dividing circuit 42 outputs a signal with a divided frequency varied in the range of 181 MHz to 217 MHz according to the reception frequency. The divided-frequency signal is further supplied to a frequency dividing circuit 43 at the following stage for similarly multiplying the divided frequency of the divided-frequency signal by 1/2. To be more specific, the frequency dividing circuit 43 outputs divided-frequency signals SLA and SLB, which each have a divided frequency varied in the range of 90.5 MHz to 108.5 MHz according to the reception frequency and have phases shifted from each other by 90 degrees. The divided-frequency signals SLA and SLB are then supplied to the mixer circuits 31A and 31B by way of the switch circuits 44A and 44B respectively as local-oscillation signals.

The mixer circuits 31A and 31B mix the received signal SRX with the local-oscillation signals SLA and SLB respectively, converting the received signal SRX into 2 intermediate-frequency signals SIFA and SIFB, which have phases shifted from each other by 90 degrees. That is to say, the mixer circuits 31A and 31B convert the frequency of the received signal SRX to produce the in-phase and quadrature intermediate-frequency signals SIFA and SIFB, which are orthogonal to each other. It should be noted that the received signal SRX has a frequency in the range of 90 MHz to 108 MHz. At that time, the local-oscillation signals SLA and SLB are each generated with a divided frequency in the range of 90.5 MHz to 108.5 MHz for the frequency of the received signal SRX. As a result, the intermediate-frequency signals SIFA and SIFB each have a frequency of 500 kHz, which is equal to the difference between the frequency of the received signal SRX and the frequency of the local-oscillation signals SLA and SLB respectively.

It should be noted that the PLL circuit 41 supplies a part of a control voltage applied to a variable-capacitance diode employed in a resonance circuit 41C of a VCO not shown in the figure to the tuning circuits 12L and 14L as a tuning voltage for implementing tuning for the received signal SRX.

The intermediate-frequency signals SIFA and SIFB generated by the mixer circuits 31A and 31B are supplied to phase shift circuits 33A and 33B by way of low-pass filters 32A and 32B respectively. The phase shift circuits 33A and 33B carry out phase processing on the intermediate-frequency signals SIFA and SIFB so that an original signal component of the intermediate-frequency signal SIFA has the same phase as an original signal component of the intermediate-frequency signal SIFB while an image component of the intermediate-frequency signal SIFA has a phase opposite to an image component of the intermediate-frequency signal SIF. Signals completed the phase processing at the phase shift circuits 33A and 33B are supplied to an adder 34 in which the image component of the intermediate-frequency signal SIFA and the image component of the intermediate-frequency signal SIFB cancel out each other. Thus, the adder 34 generates an intermediate-frequency signal SIF having the original signal component but with the image component canceled out.

Then, the intermediate-frequency signal SIF is supplied to an output terminal 38 through a signal line passing through a band-pass filter 35 for intermediate-frequency filtering, an AGC variable-gain amplifier 36 and a low-pass filter 37.

The intermediate-frequency signal SIF supplied to the output terminal 38 is subjected to various kinds of demodulation processing corresponding to ISDB-T modulation processing carried out to transmit the ISDB-T broadcasted signal. Not shown in the figure, pieces of demodulation processing include complex Fourier transformation, frequency de-interleave, time de-interleave, selection of digital audio data of a desired channel among a plurality of channels, error correction, data decompression and D/A conversion. As a result of the demodulation processing, an audio signal of a desired program selected among a plurality of programs or a plurality of channels is generated.

At that time, the intermediate-frequency signal SIF output by the low-pass filter 37 is supplied to an AGC detection circuit 45 for generating an AGC voltage V45. The AGC voltage V45 is applied to the variable-gain amplifier 36 as a signal for controlling the gain of the amplifier 36. The AGC voltage V45 is also supplied to the variable-gain amplifier 13L by way of an adder 47 as a signal for controlling the gain of the amplifier 13L. The AGC voltage V45 is used for performing AGC on the variable-gain amplifier 36 and the variable-gain amplifier 13L.

In addition, the intermediate-frequency signals SIFA and SIFB output by the low-pass filters 32A and 32B respectively are supplied to an AGC detection circuit 46 for generating an AGC voltage V46. The AGC voltage V46 is also supplied to the variable-gain amplifier 13L by way of the adder 47 as a signal for controlling the gain of the amplifier 13L. The AGC voltage V46 is used for reducing the gain of the variable-gain amplifier 13L in case the levels of noise components included in the intermediate-frequency signals SIFA and SIFB exceed a prescribed value.

The configuration and the operations for receiving low-band broadcasts have been explained so far. By having the system controller change a frequency division rate of a variable-rate frequency dividing circuit employed in the PLL circuit 41, the frequency of the oscillation signal S41 can be varied accordingly. It should be noted that the variable-rate frequency dividing circuit is not shown in the figure.

Thus, by changing the oscillation frequency in the range of 362 MHz to 434 MHz according to a reception frequency as described above, the local-oscillation signals SLA and SLB will each have a frequency varied in the range of 90.5 MHz to 108.5 MHz according to the reception frequency. Accordingly, it is possible to obtain an intermediate-frequency signal SIF with an intermediate frequency of 500 kHz, that is, to receive a low-band broadcast.

### Reception of high-band broadcasts

The antenna 11 receives an ISDB-T broadcasted wave. The antenna tuning circuit 12H fetches a received signal SRX having a desired frequency in the high band. The received signal SRX is then supplied to the mixer circuits 31A and 31B through signal lines by way of an AGC variable-gain amplifier 13H, an inter-stage tuning circuit 14H adopting the electronic tuning technique and the switch circuit 15.

The PLL circuit 41 generates an oscillation signal S41 with a frequency varied in the range of 341 MHz to 445 MHz according to the reception frequency. The oscillation signal S41 is supplied to the frequency dividing circuit 42 for multiplying the frequency of the oscillation signal S41 by 1/2. To be more specific, the frequency dividing circuit 42 outputs divided-frequency signals SHA and SHB, which each have a divided frequency varied in the range of 170.5 MHz to 222.5 MHz according to the reception frequency, and have phases shifted from each other by 90 degrees. The divided-frequency signals SHA and SHB are then supplied to the mixer circuits 31A and 31B by way of the switch circuits 44A and 44B respectively as local-oscillation signals.

The mixer circuits 31A and 31B mix the received signal SRX with the local-oscillation signals SHA and SHB respectively, converting the received signal SRX into 2 intermediate-frequency signals SIFA and SIFB, which have phases shifted from each other by 90 degrees. That is to say, the mixer circuits 31A and 31B convert the frequency of the received signal SRX to produce the in-phase and quadrature intermediate-frequency signals SIFA and SIFB, which are orthogonal to each other. It should be noted that the received signal SRX has a frequency in the range of 170 MHz to 222 MHz. At that time, the local-oscillation signals SHA and SHB are each generated with a divided frequency in the range of 170.5 MHz to 222.5 MHz for the frequency of the received signal SRX. As a result, the intermediate-frequency signals SIFA and SIFB each have a frequency of 500 kHz, which is equal to the difference between the frequency of the received signal SRX and the frequency of the local-oscillation signals SHA and SHB respectively.

It should be noted that the PLL circuit 41 supplies a part of a control voltage applied to the variable-capacitance diode employed in the VCO to the tuning circuits 12H and 14H as a tuning voltage for implementing tuning for the received signal SRX.

The intermediate-frequency signals SIFA and SIFB generated by the mixer circuits 31A and 31B are processed by the circuits 32A to 37 in the same way as the reception of a low-band broadcast. An intermediate-frequency signal SIF resulting from the processing is supplied to the output terminal 38. The intermediate-frequency signal SIF supplied to the output terminal 38 is then subjected to demodulation to produce an audio signal of a desired program.

At that time, AGC is carried out on the circuits 45 to 47 in the same way as the reception of a low-band broadcast.

The configuration and the operations for receiving high-band broadcasts have been explained so far. By having the system controller change a frequency division rate of a variable-rate frequency dividing circuit employed in the PLL circuit 41, the oscillation frequency of the oscillation signal S41 can be varied accordingly. Thus, by changing the oscillation frequency in the range of 341 MHz to 445 MHz according to a reception frequency as described above, the local-oscillation signals SHA and SHB will each have a frequency varied in the range of 170.5 MHz to 222.5 MHz according to the reception frequency. Accordingly, it is possible to obtain an intermediate-frequency signal SIF with an intermediate frequency of 500 kHz, that is, to receive a high-band broadcast.

### Summary

The oscillation frequency of the oscillation signal S41 generated by the PLL circuit 41 employed in the receiver shown in Fig. 1 has the following values:
In reception of a low-band broadcast: In the range of 362 MHz to 434 MHz
In reception of a high-band broadcast: In the range of 341 MHz to 445 MHz
It is obvious that the frequency variation range for reception of a low-band broadcast is included in the frequency variation range for reception of a high-band broadcast. With those variation ranges of the oscillation frequency, it is not necessary to switch the frequency band from one to another when the PLL circuit 41 generates the oscillation signal S41.

It is thus unnecessary to switch the resonance circuit 41C employed in the PLL circuit 41 from a coil and a variable-capacitance diode to others. As a result, the number of external components attached to the IC can be reduced and, in addition, the decreased number of external components contributes to reduction of the cost and the size of the receiver.

In addition, since it is not necessary to connect a switch device for switching the frequency band of the oscillation frequency from one to another to the oscillation circuit 41C, the Q value of the oscillation circuit 41C is not lowered. As a result, the oscillation circuit 41C exhibits improved characteristics such as stable oscillation, fewer phase noises, fewer pulling phenomena and a lower current consumption.

In addition, since the receiver needs only one oscillation circuit, which is prone to effects of surroundings, that is, the receiver needs only one VCO of the PLL circuit 41, a layout is easy to make in the implementation of the IC, and it is hence possible to design an oscillation circuit that is proof against external disturbances. Moreover, since the tracking error characteristic is uniform independently of the reception band, the number of tracking errors can be reduced with ease.

Furthermore, since the reception band can be switched from one to another with the VCO of the PLL circuit 41 kept in a state of oscillation as it is, a broadcast can be received fast even after band switching. On the top of that, it is possible to implement most of the circuits such as those enclosed by a dashed line in Fig. 1 as a single-chip IC.

### Switch circuit 15 and its peripheral circuits

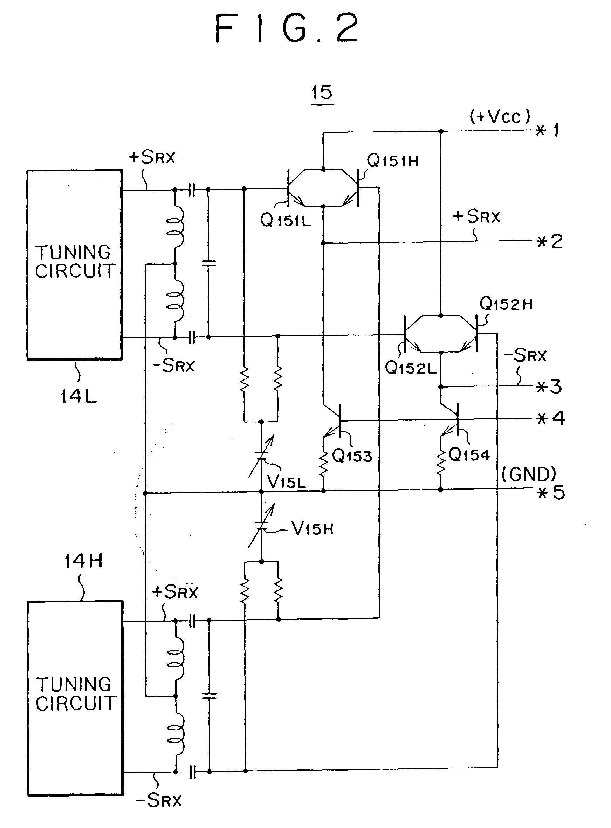

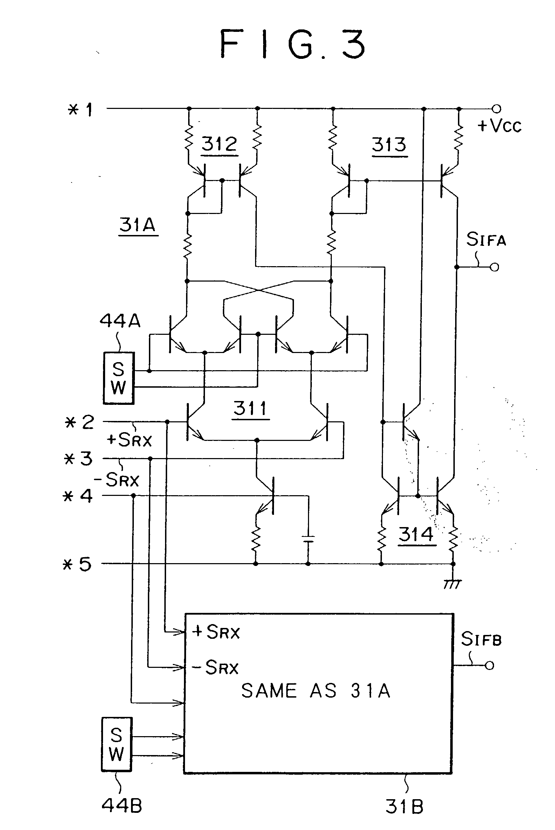

Figs. 2 and 3 are diagrams showing a typical switch circuit 15 and typical mixer circuits 31A and 31B provided at a stage following the switch circuit 15. It should be noted that portions denoted by reference numerals ^{*}1 to ^{*}5 shown in Fig. 2 are continued to portions denoted by reference numerals ^{*}1 to ^{*}5 shown in Fig. 3 respectively.

The tuning circuit 14L outputs balanced received signals ± SRX, which are supplied to the bases of transistors Q151L and Q152L respectively. The emitters of the transistors Q151L and Q152L are respectively connected to transistors Q153 and Q154 each serving as a constant-current source to form emitter followers.

In the same way, the tuning circuit 14H outputs balanced received signals ± SRX which are supplied to the bases of transistors Q151H and Q152H respectively. The emitters of the transistors Q151H and Q152H are respectively connected to the transistors Q153 and Q154 each serving as a constant-current source to form the emitter followers.

In addition, control voltages V15L and V15H are generated. The control voltage V15L is supplied to the transistors Q151L and Q152L as a base bias voltage. On the other hand, the control voltage V15H is supplied to the transistors Q151H and Q152H as a base bias voltage. The system controller controls the control voltages V15L and V15H in accordance with the reception band. To put it in detail, the control voltage V15L is set at "H" while the control voltage V15H is reset to "L" for reception of a low-band broadcast. On the other hand, the control voltage V15L is reset at "L" while the control voltage V15H is set at "H" for reception of a high-band broadcast.

The mixer circuit 31A comprises a double-balanced multiplier 311 and current mirror circuits 312 to 314 for combining outputs of the multiplier 311. The multiplier 311 inputs the received signals ± SRX generated by the switch circuit 15 and the local-oscillation signal SLA or SHA output by the switch circuit 44A. The mixer circuit 31B has the same configuration as the mixer circuit 31A. It should be noted that the frequency dividing circuits 42 and thus the switch circuits 44A and 44B output balanced divided-frequency signals ± SHA and ± SHB respectively. By the same token, the frequency dividing circuits 43 and thus the switch circuits 44A and 44B output balanced divided-frequency signals ± SLA and ± SLB respectively.

Thus, in reception of a low-band broadcast, the control voltage V15L turns on the transistors Q151L and Q152L while the control voltage V15H turns off the transistors Q151H and Q152H. Therefore, the reception signals ± SRX output by the tuning circuit 14L are supplied to the mixer circuits 31A and 31B by way of the transistors Q151L and Q152L respectively.

At that time, the divided-frequency signals ± SLA and ± SLB are supplied to the mixer circuits 31A and 31B by way of the switch circuits 44A and 44B respectively as local-oscillation signals. As a result, the mixer circuits 31A and 31B generate intermediate-frequency signals SIFA and SIFB respectively for the received low-band broadcast.

In reception of a high-band broadcast, on the other hand, the control voltage V15L turns off the transistors Q151L and Q152L while the control voltage V15H turns on the transistors Q151H and Q152H. Thus, the reception signals ± SRX output by the tuning circuit 14H are supplied to the mixer circuits 31A and 31B by way of the transistors Q151H and Q152H respectively.

At that time, the divided-frequency signals ± SHA and ± SHB are supplied to the mixer circuits 31A and 31B by way of the switch circuits 44A and 44B respectively as local-oscillation signals. As a result, the mixer circuits 31A and 31B generate intermediate-frequency signals SIFA and SIFB respectively for the received high-band broadcast.

### Receiver ---Part II

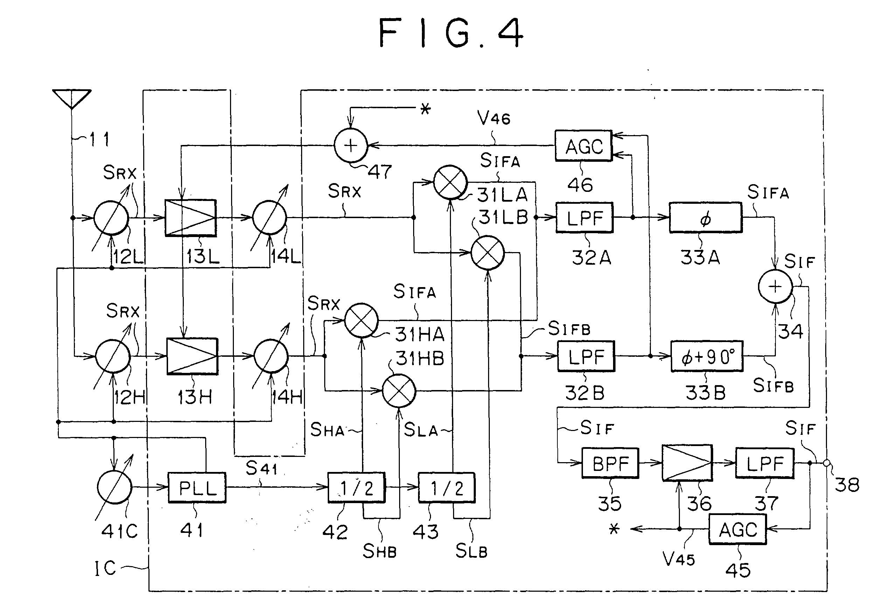

Fig. 4 is a diagram showing another typical receiver adopting the super-heterodyne system as provided by another embodiment of the present invention. In this receiver, the functions of the switch circuits 15, 44A and 44B employed in the receiver shown in Fig. 1 are included in mixer circuits.

For the above reason, there are provided 2 pairs of mixer circuits. One of the pair consists of mixer circuits 31LA and 31LB while the other pair consists of mixer circuits 31HA and 31HB. The system controller controls direct-current bias voltages for the mixer circuits 31LA, 31LB, 31HA and 31HB in accordance with the reception band. To put it in detail; bias voltages for transistors composing the mixer circuits 31LA, 31LB, 31HA and 31HB are controlled so that, when a low-band broadcast is received, the mixer circuits 31LA and 31LB are operating effectively and, when a high-band broadcast is received, on the other hand, the mixer circuits 31HA and 31HB are operating effectively.

Next, configurations and operations for receiving low-band and high-band broadcasts are explained.

### Reception of low-band broadcasts

An antenna 11 receives an ISDB-T broadcasted wave. An antenna tuning circuit 12L fetches a received signal SRX having a desired frequency in the low band. The received signal SRX is then supplied to the mixer circuits 31LA and 31LB through signal lines by way of an AGC variable-gain amplifier 13L and an inter-stage tuning circuit 14L adopting the electronic tuning technique.

A PLL circuit 41 generates an oscillation signal S41 with a frequency varied in the range of 362 MHz to 434 MHz according to the reception frequency. The oscillation signal S41 is supplied to a frequency dividing circuit 42, being converted into a signal with a divided frequency varied in the range of 181 MHz to 217 MHz according to the reception frequency. The divided-frequency signal is further supplied to a frequency dividing circuit 43 at the following stage, being converted into 2 divided-frequency signals SLA and SLB, which each have a divided frequency varied in the range of 90.5 MHz to 108.5 MHz according to the reception frequency and have phases shifted from each other by 90 degrees. The divided-frequency signals SLA and SLB are then supplied to the mixer circuits 31LA and 31LB respectively as local-oscillation signals.

The mixer circuits 31LA and 31LB mix the received signal SRX with the local-oscillation signals SLA and SLB respectively, converting the received signal SRX into 2 intermediate-frequency signals SIFA and SIFB, which have phases shifted from each other by 90 degrees. That is to say, the mixer circuits 31A and 31B convert the frequency of the received signal SRX to produce the in-phase and quadrature intermediate-frequency signals SIFA and SIFB, which are orthogonal to each other. It should be noted that the intermediate-frequency signals SIFA and SIFB each have an intermediate frequency of 500 kHz.

The intermediate-frequency signals SIFA and SIFB are supplied to an adder 34 by way of low-pass filters 32A and 32B and phase shift circuits 33A and 33B respectively. The adder 34 generates an intermediate-frequency signal SIF having the original signal component but with the image component canceled out.

Then, the intermediate-frequency signal SIF is supplied to an output terminal 38 through signal lines passing through a band-pass filter 35 for intermediate-frequency filtering, an AGC variable-gain amplifier 36 and a low-pass filter 37. The intermediate-frequency signal SIF supplied to the output terminal 38 is then supplied to a demodulation circuit not shown in the figure. As a result of demodulation, an audio signal of a desired program selected among a plurality of programs is generated.

At that time, AGC voltages V45 and V46 are generated from the intermediate-frequency signals SIF, SIFA and SIFB to be used in AGC in the same way as the receiver shown in Fig. 1.

The configuration and the operations for receiving low-band broadcasts have been explained so far. By having the system controller change a frequency division rate of a variable-rate frequency dividing circuit employed in the PLL circuit 41, the frequency of the oscillation signal S41 can be varied accordingly. Thus, by changing the oscillation frequency in the range of 362 MHz to 434 MHz according to a reception frequency as described above, the local-oscillation signals SLA and SLB will each have a frequency varied in the range of 90.5 MHz to 108.5 MHz according to the reception frequency. Accordingly, it is possible to obtain an intermediate-frequency signal SIF with an intermediate frequency of 500 kHz, that is, to receive a low-band broadcast.

### Reception of high-band broadcasts

The antenna 11 receives an ISDB-T broadcasted wave. An antenna tuning circuit 12H fetches a received signal SRX having a desired frequency in the high band. The received signal SRX is then supplied to the mixer circuits 31HA and 31HB through signal lines by way of an AGC variable-gain amplifier 13H and an inter-stage tuning circuit 14H adopting the electronic tuning technique.

The PLL circuit 41 generates an oscillation signal S41 with a frequency varied in the range of 341 MHz to 445 MHz according to the reception frequency. The oscillation signal S41 is supplied to the frequency dividing circuit 42, being converted into 2 divided-frequency signals SHA and SHB, which each have a divided frequency varied in the range of 170.5 MHz to 222.5 MHz according to the reception frequency and have phases shifted from each other by 90 degrees. The divided-frequency signals SHA and SHB are then supplied to the mixer circuits 31HA and 31HB respectively as local-oscillation signals.

The mixer circuits 31HA and 31HB mix the received signal SRX with the local-oscillation signals SHA and SHB respectively, converting the received signal SRX into 2 intermediate-frequency signals SIFA and SIFB, which have phases shifted from each other by 90 degrees. That is to say, the mixer circuits 31A and 31B convert the frequency of the received signal SRX to produce the in-phase and quadrature intermediate-frequency signals SIFA and SIFB, which are orthogonal to each other. It should be noted that the intermediate-frequency signals SIFA and SIFB each have an intermediate frequency of 500 kHz.

The intermediate-frequency signals SIFA and SIFB are processed in the circuits 32A to 37 in the same way as the reception of a low-band broadcast to produce an intermediate-frequency signal SIF supplied to the output terminal 38. The intermediate-frequency signal SIF supplied to the output terminal 38 is then supplied to a demodulation circuit provided at the next stage. As a result of demodulation, an audio signal of a desired program selected among a plurality of programs is generated.

At that time, the circuits 45 to 47 carry out AGC in the same way as the reception of a low-band broadcast.

The configuration and the operations for receiving high-band broadcasts have been explained so far. By having the system controller change a frequency division rate of a variable-rate frequency dividing circuit employed in the PLL circuit 41, the frequency of the oscillation signal S41 can be varied accordingly. Thus, by changing the oscillation frequency of the oscillation signal S41 in the range of 341 MHz to 445 MHz according to a reception frequency as described above, the local-oscillation signals SHA and SHB will each have a frequency varied in the range of 170.5 MHz to 222.5 MHz according to the reception frequency. Accordingly, it is possible to obtain an intermediate-frequency signal SIF with an intermediate frequency of 500 kHz, that is, to receive a high-band broadcast.

### Summary

Much like the receiver shown in Fig. 1, the oscillation frequency of the oscillation signal S41 generated by the PLL circuit 41 employed in the receiver shown in Fig. 4 has the following values:
In reception of a low-band broadcast: In the range of 362 MHz to 434 MHz
In reception of a high-band broadcast: In the range of 341 MHz to 445 MHz
It is thus unnecessary to switch the resonance circuit 41C employed in the PLL circuit 41 from a coil and a variable-capacitance diode to others. As a result, the number of external components attached to the IC can be reduced and, in addition, the decreased number of external components contributes to reduction of the cost and the size of the receiver.

In addition, since it is not necessary to connect a switch device for switching the frequency band of the oscillation frequency from one to another to the oscillation circuit 41C, the Q value of the oscillation circuit 41C is not lowered. As a result, the oscillation circuit 41C exhibits improved characteristics.

In addition, since the reception band is switched from one to another by controlling direct-current bias voltages of the mixer circuits 31LA, 31LB, 31HA and 31HB, the current consumption can be reduced. To put it in detail, in the case of the receiver shown in Fig. 1, the switch circuits 15, 44A and 44B directly switch the high-frequency signals, namely, the received signal SRX and the local-oscillation signals SLA to SHB from ones to others. Thus, the switch circuits 15, 44A and 44B consume large currents. In the case of the receiver shown in Fig. 4, on the other hand, such high-frequency signals are not subjected to switching so that the current consumption can be reduced.

### Mixer circuits 31LA to 31HB

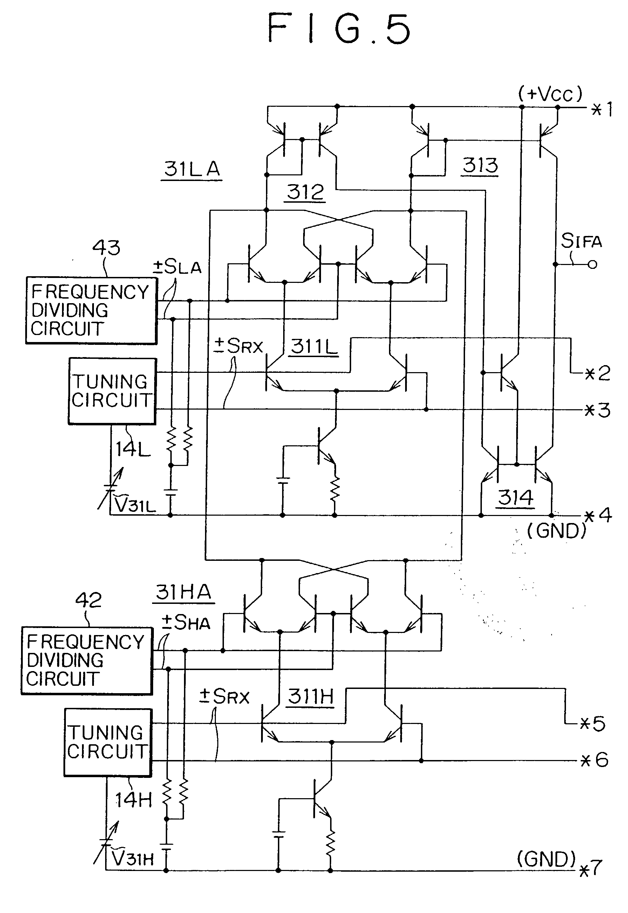

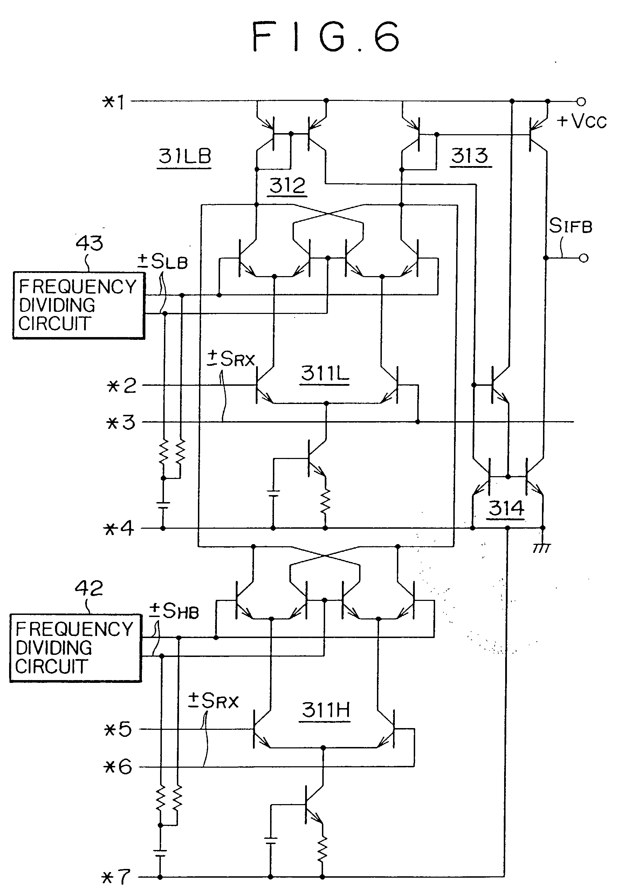

Figs. 5 and 6 are diagrams showing typical mixer circuits 31LA to 31HB. It should be noted that portions denoted by reference numerals *1 to *7 shown in Fig. 5 are continued to portions denoted by reference numerals *1 to *7 shown in Fig. 6 respectively. The mixer circuit 31LA comprises a double-balanced multiplier 311L and current mirror circuits 312 to 314 for combining outputs of the multiplier 311L.

The tuning circuit 14L outputs balanced received signals ± SRX of a low-band broadcast, which are supplied to the multiplier 311L. At that time, a control voltage V31L is used for controlling the effect of the received signals ± SRX by being supplied to transistors employed in the multiplier 311L as a base bias voltage. The frequency dividing circuit 43 outputs balanced divided-frequency signals ± SLA, which are each supplied to the mixer circuit 31LA as a local-oscillation signal.

On the other hand, a double-balanced multiplier 311H is connected to the current mirror circuits 312 and 313. The double-balanced multiplier 311H and the current mirror circuits 312 to 314 compose the mixer circuit 31HA.

The tuning circuit 14H outputs balanced received signals ± SRX of a high-band broadcast. The received signals ± SRX are supplied to the multiplier 311H. At that time, a control voltage V31H is used for controlling the effect of the received signals ± SRX by being supplied to transistors employed in the multiplier 311H as a base bias voltage. The frequency dividing circuit 42 outputs balanced divided-frequency signals ± SHA, which are each supplied to the mixer circuit 31HA as a local-oscillation signal.

The mixer circuits 31LB and 31HB have the same configurations as the mixer circuits 31LA and 31HA respectively. In the case of the mixer circuit 31LB, the tuning circuit 14L outputs balanced received signals ± SRX of a low-band broadcast. At that time, the control voltage V31L is used for controlling the effect of the received signals ± SRX by being supplied to the mixer circuit 31LB along with the received signals ± SRX. The frequency dividing circuit 43 outputs balanced divided-frequency signals ± SLB, which are each supplied to the mixer circuit 31LB as a local-oscillation signal.

In the case of the mixer circuit 31HB, on the other hand, the tuning circuit 14H outputs balanced received signals ± SRX of a high-band broadcast. At that time, the control voltage V31H is used for controlling the effect of the received signals ± SRX by being supplied to the mixer circuit 31HB along with the received signals ± SRX. The frequency dividing circuit 42 outputs balanced divided-frequency signals ± SHB, which are each supplied to the mixer circuit 31HB as a local-oscillation signal.

The system controller controls the control voltages V31L and V31H in accordance with the reception band. To put it in detail, the control voltage V31L is set at "H" while the control voltage V31H is reset to "L" for reception of a low-band broadcast. On the other hand, the control voltage V31L is reset to "L" while the control voltage V31H is set at "H" for reception of a high-band broadcast.

Thus, when a low-band broadcast is being received, the control voltage V31L puts the multipliers 311L employed in the mixer circuits 31LA and 31LB in an operating state while the control voltage V31H puts the multipliers 311H employed in the mixer circuits 31HA and 31HB in a non-operating state. As a result, the multipliers 311L convert the received signals ± SRX of the low-band broadcast into intermediate-frequency signals ± SIFA and ± SIFB by using the local-oscillation signals ± SLA and ± SLB respectively. The current mirror circuits 312 to 314 convert the intermediate-frequency signals ± SIFA and ± SIFB into intermediate-frequency signals SIFA and SIFB respectively, and output the intermediate-frequency signals SIFA and SIFB.

In the same way, when a high-band broadcast is being received, the control voltage V31H puts the multipliers 311H employed in the mixer circuits .31HA and 31HB in an operating state while the control voltage V31L puts the multipliers 311H employed in the mixer circuits 31LA and 31LB in a non-operating state. As a result, the multipliers 311H convert the received signals ± SRX of the high-band broadcast into intermediate-frequency signals ± SIFA and ± SIFB by using the local-oscillation signals ± SHA and ± SHB respectively. The current mirror circuits 312 to 314 convert the intermediate-frequency signals ± SIFA and ± SIFB into intermediate-frequency signals SIFA and SIFB respectively, and output the intermediate-frequency signals SIFA and SIFB.

In this way, the circuits shown in Figs. 5 and 6 convert the frequency of the received signal SRX of a low-band or high-band broadcast to produce the intermediate-frequency signals SIFA and SIFB respectively. In this case, it is not necessary to switch the received signal SRX as well as the local-oscillation signals from SLA to SHA and from SLB to SHB or vice versa in accordance with the reception band. As a result, it is possible to eliminate consumption of currents that would otherwise be required for the switching operations in the conventional receiver.

### Receiver ---Part III

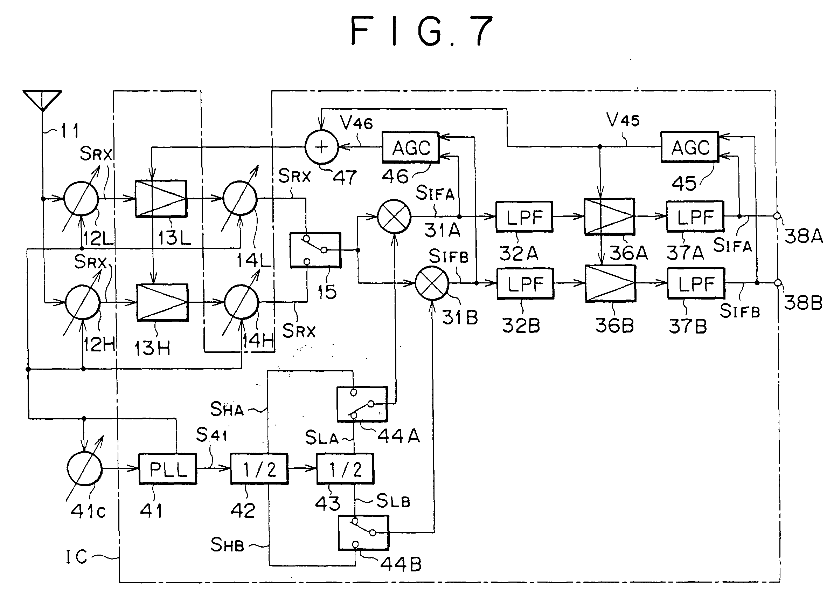

Fig. 7 is a diagram showing a typical receiver adopting the direct-conversion system for the narrow-band ISDB-T standard as provided by a further embodiment of the present invention. Much like the receiver shown in Fig. 1, this receiver includes switch circuits 15, 44A and 44B for switching the reception band from one to another. In accordance with control executed by a system controller, which is not shown in the figure, the switch circuits 15 to 44B are connected in a state of connection for receiving a low-band broadcast as shown in the figure. When receiving a high-band broadcast, however, the switch circuits 15 to 44B are connected in a state of connection opposite to the state shown in the figure. Circuits enclosed by a dashed line are implemented as a single-chip IC.

Next, configurations and operations for receiving low-band and high-band broadcasts are explained.

### Reception of low-band broadcasts

An antenna 11 receives an ISDB-T broadcasted wave. An antenna tuning circuit 12L fetches a received signal SRX having a desired frequency in the low band. The received signal SRX is then supplied to mixer circuits 31A and 31B through signal lines by way of an AGC variable-gain amplifier 13L, an inter-stage tuning circuit 14L adopting the electronic tuning technique and the switch circuit 15.

A PLL circuit 41 generates an oscillation signal S41 with a frequency varied in the range of 360 MHz to 432 MHz according to the reception frequency. The oscillation signal S41 is supplied to a frequency dividing circuit 42 for multiplying the frequency of the oscillation signal S41 by 1/2. To be more specific, the frequency dividing circuit 42 outputs a signal with a divided frequency varied in the range of 180 MHz to 216 MHz according to the reception frequency. The divided-frequency signal is further supplied to a frequency dividing circuit 43 at the following stage for similarly multiplying the divided frequency of the divided-frequency signal by 1/2. To be more specific, the frequency dividing circuit 43 outputs divided-frequency signals SLA and SLB, which each have a divided frequency varied in the range of 90 MHz to 108 MHz according to the reception frequency and have phases shifted from each other by 90 degrees. The divided-frequency signals SLA and SLB are then supplied to the mixer circuits 31A and 31B by way of the switch circuits 44A and 44B respectively as local-oscillation signals.

The mixer circuits 31A and 31B mix the received signal SRX with the local-oscillation signals SLA and SLB respectively, converting the received signal SRX into 2 intermediate-frequency signals SIFA and SIFB, which have phases shifted from each other by 90 degrees. That is to say, the mixer circuits 31A and 31B convert the frequency of the received signal SRX to produce the in-phase and quadrature intermediate-frequency signals SIFA and SIFB, which are orthogonal to each other. It should be noted that the received signal SRX has a frequency in the range of 90 MHz to 108 MHz. At that time, the local-oscillation signals SLA and SLB are each generated with a divided frequency in the range of 90 MHz to 108 MHz for the frequency of the received signal SRX. As a result, the intermediate-frequency signals SIFA and SIFB each have a frequency of 0 since the reception frequency is equal to the local-oscillation frequency.

It should be noted that the PLL circuit 41 supplies a part of a control voltage applied to a variable-capacitance diode employed in a resonance circuit 41C of a VCO not shown in the figure to the tuning circuits 12L and 14L as a tuning voltage for implementing tuning for the received signal SRX.

The intermediate-frequency signal SIFA generated by the mixer circuit 31A is supplied to an output terminal 38A through signal lines by way of a low-pass filter 32A, an AGC variable-gain amplifier 36A and a low-pass filter 37A. In the same way, the intermediate-frequency signal SIFB generated by the mixer circuit 31B is supplied to an output terminal 38B through signal lines by way of a low-pass filter 32B, an AGC variable-gain amplifier 36B and a low-pass filter 37B.

The intermediate-frequency signals SIFA and SIFB supplied to the output terminals 38A and 38B respectively are each subjected to various kinds of demodulation processing corresponding to ISDB-T modulation processing carried out to transmit the ISDB-T broadcasted signal. Pieces of demodulation processing include complex Fourier transformation, frequency de-interleave, time deinterleave, selection of digital audio data of a desired channel among a plurality of channels, error correction, data decompression and D/A conversion. As a result of the demodulation processing, an audio signal of a desired program selected among a plurality of programs or a plurality of channels is generated. It should be noted that the pieces of demodulation processing are not shown in the figure.

At that time, the intermediate-frequency signals SIFA and SIFB output by the low-pass filters 37A and 37B respectively are supplied to an AGC detection circuit 45 for generating an AGC voltage V45. On the other hand, the intermediate-frequency signals SIFA and SIFB output by the mixer circuits 31A and 31B respectively are supplied to an AGC detection circuit 46 for generating an AGC voltage V46. The AGC voltages V45 and V46 are used for carrying out AGC in the same way as the receiver shown in Fig. 1.

The configuration and the operations for receiving low-band broadcasts have been explained so far. By having the system controller change a frequency division rate of a variable-rate frequency dividing circuit employed in the PLL circuit 41, the oscillation frequency can be varied accordingly. Thus, by changing the oscillation frequency in the range of 360 MHz to 432 MHz according to a reception frequency as described above, the local-oscillation signals SLA and SLB will each have a frequency varied in the range of 90 MHz to 108 MHz according to the reception frequency. Accordingly, it is possible to obtain intermediate-frequency signals SIFA and SIFB each with an intermediate frequency of 0, that is, to receive a low-band broadcast.

### Reception of high-band broadcasts

The antenna 11 receives an ISDB-T broadcasted wave. An antenna tuning circuit 12H fetches a received signal SRX having a desired frequency in the high band. The received signal SRX is then supplied to the mixer circuits 31A and 31B through signal lines by way of an AGC variable-gain amplifier 13H, an inter-stage tuning circuit 14H adopting the electronic tuning technique and the switch circuit 15.

The PLL circuit 41 generates an oscillation signal S41 with a frequency varied in the range of 340 MHz to 444 MHz according to the reception frequency. The oscillation signal S41 is supplied to the frequency dividing circuit 42 for multiplying the frequency of the oscillation signal S41 by 1/2. To be more specific, the frequency dividing circuit 42 outputs divided-frequency signals SHA and SHB, which each have a divided frequency varied in the range of 170 MHz to 222 MHz according to the reception frequency, and have phases shifted from each other by 90 degrees. The divided-frequency signals SHA and SHB are then supplied to the mixer circuits 31A and 31B by way of the switch circuits 44A and 44B respectively as local-oscillation signals.

The mixer circuits 31A and 31B mix the received signal SRX with the local-oscillation signals SHA and SHB respectively, converting the received signal SRX into 2 intermediate-frequency signals SIFA and SIFB, which have phases shifted from each other by 90 degrees. That is to say, the mixer circuits 31A and 31B convert the frequency of the received signal SRX to produce the in-phase and quadrature intermediate-frequency signals SIFA and SIFB, which are orthogonal to each other. It should be noted that the received signal SRX has a frequency in the range of 170 MHz to 222 MHz. At that time, the local-oscillation signals SHA and SHB are each generated with a divided frequency in the range of 170 MHz to 222 MHz according to the frequency of the received signal SRX. As a result, the intermediate-frequency signals SIFA and SIFB each have a frequency of 0 since the reception frequency is equal to the local oscillation frequency.

It should be noted the PLL circuit 41 supplies a part of a control voltage applied to the variable-capacitance diode employed in the VCO to the tuning circuits 12H and 14H as a tuning voltage for implementing tuning for the received signal SRX.

The intermediate-frequency signals SIFA and SIFB generated by the mixer circuits 31A and 31B respectively are processed by the circuits 32A to 37 in the same way as the reception of a low-band broadcast. Intermediate-frequency signals SIFA and SIFB resulting from the processing are supplied to the output terminals 38A and 38B respectively. The intermediate-frequency signals SIFA and SIFB supplied to the output terminals 38A and 38B are then subjected to demodulation to produce an audio signal of a desired program.

At that time, AGC is carried out on the circuits 45 to 47 in the same way as the reception of a low-band broadcast.

The configuration and the operations for receiving high-band broadcasts have been explained so far. By having the system controller change a frequency division rate of a variable-rate frequency dividing circuit employed in the PLL circuit 41, the oscillation frequency of the oscillation signal S41 can be varied accordingly. Thus, by changing the oscillation frequency in the range of 340 MHz to 444 MHz according to a reception frequency as described above, the local-oscillation signals SHA and SHB will each have a frequency varied in the range of 170 MHz to 222 MHz according to the reception frequency. Accordingly, it is possible to obtain intermediate-frequency signals SIFA and SIFB with an intermediate frequency of 0, that is, to receive a high-band broadcast.

### Summary

The oscillation frequency of the oscillation signal S41 generated by the PLL circuit 41 employed in the receiver shown in Fig. 7 has the following values:
In reception of a low-band broadcast: In the range of 360 MHz to 432 MHz
In reception of a high-band broadcast: In the range of 340 MHz to 444 MHz
Thus, this receiver exhibits the same effects as the receiver shown in Fig. 1.

### Receiver ---Part IV

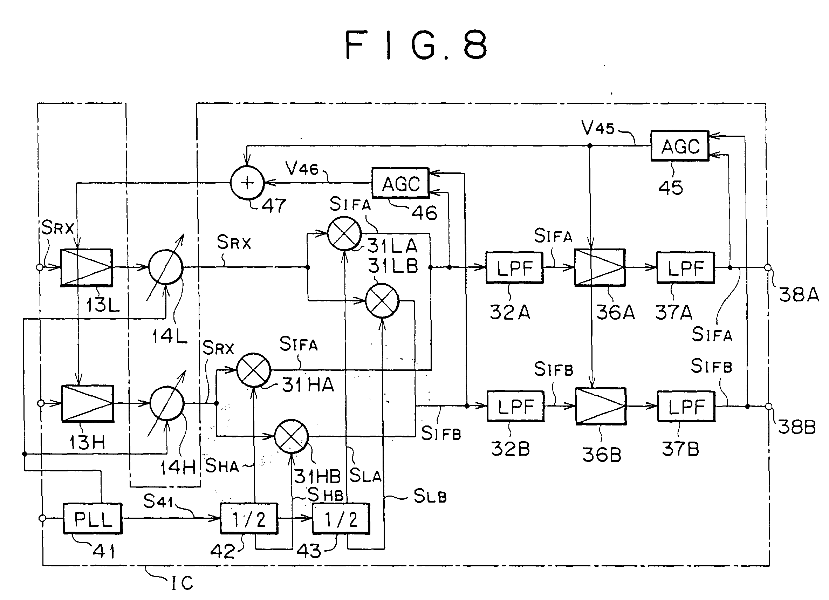

Fig. 8 is a diagram showing another typical receiver adopting the direct-conversion system as provided by a still further embodiment of the present invention. Much like the receiver shown in Fig. 4, in this receiver, the functions of the switch circuits 15, 44A and 44B are included in mixer circuits. It should be noted that Fig. 8 shows neither the antenna tuning circuits 12L and 12H nor the oscillation circuit 41C due to page-size limitation.

For the above reason, there are provided 2 pairs of mixer circuits. One of the pair consists of mixer circuits 31LA and 31LB while the other pair consists of mixer circuits 31HA and 31HB. The system controller controls direct-current bias voltages for the mixer circuits 31LA, 31LB, 31HA and 31HB in accordance with the reception band. To put it in detail, bias voltages for transistors composing the mixer circuits 31LA, 31LB, 31HA and 31HB are controlled so that, when a low-band broadcast is received, the mixer circuits 31LA and 31LB are operating effectively and, when a high-band broadcast is received, on the other hand, the mixer circuits 31HA and 31HB are operating effectively.

Next, configurations and operations for receiving low-band and high-band broadcasts are explained.

### Reception of low-band broadcasts

A received signal of an ISDB-T broadcasted wave is supplied to the mixer circuits 31LA and 31LB through signal lines by way of an antenna tuning circuit, an AGC variable-gain amplifier 13L and an inter-stage tuning circuit 14L adopting the electronic tuning technique. It should be noted that the antenna tuning circuit is not shown in the figure.

A PLL circuit 41 generates an oscillation signal S41 with a frequency varied in the range of 360 MHz to 432 MHz according to a reception frequency. The oscillation signal S41 is supplied to a frequency dividing circuit 42, being converted into a signal with a divided frequency varied in the range of 180 MHz to 216 MHz according to the reception frequency. The divided-frequency signal is further supplied to a frequency dividing circuit 43 at the following stage, being converted into 2 divided-frequency signals SLA and SLB, which each have a divided frequency varied in the range of 90 MHz to 108 MHz according to the reception frequency and have phases shifted from each other by 90 degrees. The divided-frequency signals SLA and SLB are then supplied to the mixer circuits 31LA and 31LB respectively as local-oscillation signals.

The mixer circuits 31LA and 31LB mix the received signal SRX with the local-oscillation signals SLA and SLB respectively, converting the received signal SRX into 2 intermediate-frequency signals SIFA and SIFB, which have phases shifted from each other by 90 degrees. That is to say, the mixer circuits 31A and 31B convert the frequency of the received signal SRX to produce the in-phase and quadrature intermediate-frequency signals SIFA and SIFB, which are orthogonal to each other. It should be noted that the intermediate-frequency signals SIFA and SIFB each have an intermediate frequency of 0.

The intermediate-frequency signal SIFA generated by the mixer circuit 31A is supplied to an output terminal 38A through signal lines by way of a low-pass filter 32A, an AGC variable-gain amplifier 36A and a low-pass filter 37A. In the same way, the intermediate-frequency signal SIFB generated by the mixer, circuit 31B is supplied to an output terminal 38B through signal lines by way of a low-pass filter 32B, an AGC variable-gain amplifier 36B and a low-pass filter 37B.

It should be noted that the intermediate-frequency signals SIFA and SIFB supplied to the output terminals 38A and 38B respectively are then subjected to modulation. As a result of demodulation, an audio signal of a desired program is generated.

In addition, AGC detection circuits 45 and 46 generate AGC voltages V45 and V46 respectively, which are used for carrying out AGC of the AGC variable-gain amplifiers 36A, 36B and 13L.

The configuration and the operations for receiving low-band broadcasts have been explained so far. By having the system controller change a frequency division rate of a variable-rate frequency dividing circuit employed in the PLL circuit 41, the frequency of the oscillation signal S41 can be varied accordingly. It should be noted that the variable-rate frequency dividing circuit itself is not shown in the figures. Thus, by changing the oscillation frequency in the range of 360 MHz to 432 MHz according to a reception frequency as described above, the local-oscillation signals SLA and SLB will each have a frequency varied in the range of 90 MHz to 108 MHz according to the reception frequency. Accordingly, it is possible to obtain intermediate-frequency signals SIFA and SIFB each having an intermediate frequency of 0, that is, to receive a low-band broadcast.

### Reception of high-band broadcasts

A received signal of an ISDB-T broadcasted wave is supplied to the mixer circuits 31HA and 31HB through signal lines by way of an antenna tuning circuit, an AGC variable-gain amplifier 13H and an inter-stage tuning circuit 14H adopting the electronic tuning technique. It should be noted that the antenna tuning circuit is not shown in the figure.

The PLL circuit 41 generates an oscillation signal S41 with a frequency varied in the range of 340 MHz to 444 MHz according to a reception frequency. The oscillation signal S41 is supplied to the frequency dividing circuit 42, being converted into 2 divided-frequency signals SHA and SHB, which each have a divided frequency varied in the range of 170 MHz to 222 MHz according to the reception frequency and have phases shifted from each other by 90 degrees. The divided-frequency signals SHA and SHB are then supplied to the mixer circuits 31HA and 31HB respectively as local-oscillation signals.

The mixer circuits 31HA and 31HB mix the received signal SRX with the local-oscillation signals SHA and SHB respectively, converting the received signal SRX into 2 intermediate-frequency signals SIFA and SIFB, which have phases shifted from each other by 90 degrees. That is to say, the mixer circuits 31A and 31B convert the frequency of the received signal SRX to produce the in-phase and quadrature intermediate-frequency signals SIFA and SIFB, which are orthogonal to each other. It should be noted that the intermediate-frequency signals SIFA and SIFB each have an intermediate frequency of 0.

The intermediate-frequency signals SIFA and SIFB are processed in the circuits 32A to 37 in the same way as the reception of a low-band broadcast to produce intermediate-frequency signals SIFA and SIFB supplied to output terminals 38A and 38B respectively. The intermediate-frequency signals SIFA and SIFB supplied to the output terminals 38A and 38B are then modulated to produce an audio signal of a desired program.

At that time, the circuits 45 to 47 carry out AGC in the same way as the reception of a low-band broadcast.

The configuration and the operations for receiving high-band broadcasts have been explained so far. By having the system controller change a frequency division rate of a variable-rate frequency dividing circuit employed in the PLL circuit 41, the frequency of the oscillation signal S41 can be varied accordingly. Thus, by changing the oscillation frequency in the range of 340 MHz to 444 MHz according to a reception frequency as described above, the local-oscillation signals SHA and SHB will each have a frequency varied in the range of 170 MHz to 222 MHz according to the reception frequency. Accordingly, it is possible to obtain intermediate-frequency signals SIFA and SIFB each having an intermediate frequency of 0, that is, to receive a high-band broadcast.

### Summary

The oscillation frequency of the oscillation signal S41 generated by the PLL circuit 41 employed in the receiver shown in Fig. 8 has the following values:
In reception of a low-band broadcast: In the range of 360 MHz to 432 MHz
In reception, of a high-band broadcast: In the range of 340 MHz to 444 MHz
Thus, this receiver exhibits the same effects as the receiver shown in Fig. 4.

Since the reception band is switched from one to another by controlling the direct-current bias voltages of the mixer circuits 31LA, 31LB, 31HA and 31HB, the magnitude of the consumed current can be reduced.

### Others

The above description explains the configurations of narrow-band ISDB-T receivers. By the way, a receiver for receiving audio signals of FM and television broadcasts has the following reception bands:
FM broadcasting band: 76 MHz to 90 MHz
Television broadcasting low band: 90 MHz to 108 MHz (1 to 3 channels)
Television broadcasting high band: 170 MHz to 222 MHz (4 to 12 channels)

Thus, the reception band of a receiver for receiving audio signals of FM and television broadcasts can be divided into the following:
1: Low band: 76 MHz to 108 MHz
2: High band: 170 MHz to 222 MHz

In this case, the oscillation signal S41 generated by the PLL circuit 41 and the divided-frequency signals S42 and S43 used for converting frequencies need to be controlled as follows.

In the case of a receiver with a configuration having a super-heterodyne system as shown in Fig. 1 or 4 to produce a typical intermediate frequency of 500 kHz, for the low band (1), the frequency range of the oscillation signal S41 is set at 306 MHz to 434 MHz and the frequency of the received signal SRX is converted by using the divided-frequency signals SLA and SLB. For the high band (2), on the other hand, the frequency range of the oscillation signal S41 is set at 341 MHz to 445 MHz and the frequency of the received signal SRX is converted by using the divided-frequency signals SHA and SHB.

In the case of a receiver with a configuration adopting a direct-conversion system as shown in Fig. 7 or 8, on the contrary, the frequency range is set as follows. For the low band (1), the frequency range of the oscillation signal S41 is set at 304 MHz to 432 MHz and the frequency of the received signal SRX is converted by using the divided-frequency signals SLA and SLB. For the high band (2), on the other hand, the frequency range of the oscillation signal S41 is set at 340 MHz to 444 MHz and the frequency of the received signal SRX is converted by using the divided-frequency signals SHA and SHB.

A circuit for switching the reception band from (1) to (2) and vice versa for the above receivers may have the same configuration as that of the ISDB-T receiver shown in Figs. 2 and 3 or Figs. 5 and 6.

In addition, in the receivers described above, the tuning circuit 12L can be implemented as a band-pass filter having a low band as a pass band. By the same token, the tuning circuit 12H can be implemented as a band-pass filter having a high band as a pass band. Moreover, the phase shift circuits 33A and 33B can each be implemented as a poly-phase filter.

In accordance with embodiments of the present invention, since it is not necessary to switch a PLL resonance circuit from a variable-capacitance diode and a coil to others corresponding to the reception band, the number of external components attached to the IC can be reduced. A decreased external-component count contributes to reduction of the cost and size of the receiver.

Moreover, since it is not necessary to connect a switch device for switching the frequency band of the oscillation frequency from one to another to the PLL oscillation circuit, the Q value of the oscillation circuit is not lowered. As a result, the oscillation circuit exhibits improved characteristics such as stable oscillation, fewer phase noises, fewer pulling phenomena and a lower current consumption.

In addition, since the receiver needs only one oscillation circuit, which is prone to effects of surroundings, that is, the receiver needs only one VCO of the PLL circuit, a layout is easy to make in the implementation of the IC, and it is hence possible to design an oscillation circuit that is proof against external disturbances. On the top of that, since the tracking error characteristic is uniform independently of the reception band, the number of tracking errors can be reduced with ease.

Furthermore, since the reception band can be switched from one to another with the VCO of the PLL circuit 41 kept in a state of oscillation as it is, a broadcast can be received fast even after band switching. Moreover, it is possible to implement most of the circuits such as those enclosed by a dashed line in Fig. 1 as a single-chip IC.

Although particular embodiments have been described herein, it will be appreciated that the invention is not limited thereto and that many modifications and additions thereto may be made within the scope of the invention. For example, various combinations of the features of the following dependent claims can be made with the features of the independent claims without departing from the scope of the present invention.

### [LIST OF ABBREVIATIONS USED IN THIS SPECIFICATION]

AGC: Automatic Gain Control
AM: Amplitude Modulation
DAB: Digital Audio Broadcasting
FM: Frequency Modulation
IC: Integrated Circuit
ISDB: Integrated Services Digital Broadcasting
MPEG: Motion Picture Image Coding Experts Group
OFDM: Orthogonal Frequency Division Multiplex
PLL: Phase Locked Loop
VCO: Voltage Controlled Oscillator
VHF: Very High Frequency

## Claims

1. A reception IC comprising:
a frequency dividing circuit for dividing the frequency of an oscillation signal supplied thereto and outputting a plurality of divided-frequency signals having frequencies different from each other;
a selecting circuit for selecting one of said divided-frequency signals output by said frequency dividing circuit as a local-oscillation signal; and
a mixer circuit for being inputted said local-oscillation signal output by said selecting circuit and a received signal, converting the frequency of said received signal and outputting said received signal with said converted frequency as an intermediate-frequency signal.

2. The reception IC according to claim 1 wherein:
said selecting circuit selects one of said divided-frequency signals for a selected reception band; and
by changing the frequency of said local oscillation signal for each selected reception band, said frequency of said received signal is changed.

3. A reception IC comprising:
a received-signal-selecting circuit for selecting one of a plurality of received signals with reception bands different from each other;
a frequency dividing circuit for dividing the frequency of an oscillation signal supplied thereto and outputting a plurality of divided-frequency signals having frequencies different from each other;
a divided-frequency-signal-selecting circuit for selecting one of said divided-frequency signals output by said frequency dividing circuit as a local-oscillation signal; and
a mixer circuit for being inputted said local-oscillation signal output by said divided-frequency-signal-selecting circuit and said received signal selected by said received-signal-selecting circuit, converting the frequency of said received signal and outputting said received signal with said converted frequency as an intermediate-frequency signal,
wherein:
said received-signal-selecting circuit selects one of said received signals for a selected reception band; said divided-frequency-signal-selecting circuit selects one of said divided-frequency signals for said selected reception band; and
by changing the frequency of said local oscillation signal for each selected reception band, said frequency of said received signal is changed.

4. The reception IC according to claim 3 wherein:
said received-signal-selecting circuit comprises a plurality of amplifiers each provided for a reception band; and
said received-signal-selecting circuit selects one of said received signals for a selected reception band by activating a control signal for effectively operating one of said amplifiers for said selected reception band.

5. The reception IC according to claim 3 wherein:
said mixer circuit comprises 2 mixer sub-circuits; and
said divided-frequency signal supplied to each of said mixer sub-circuits comprises 2 signal components with phases shifted from each other by 90 degrees to generate 2 intermediate-frequency signals with phases shifted from each other by 90 degrees.

6. The reception IC according to claim 3 wherein:
said reception bands are a low band and a high band of VHF television broadcasting; and
said divided-frequency signal used as a local oscillation signal in reception of a broadcast of said low band has a frequency equal to half a frequency of said divided-frequency signal used as a local oscillation signal in reception of a broadcast of said high band.

7. The reception IC according to claim 6 wherein a band of FM broadcasting is included in said low band.

8. A reception IC comprising:
a frequency dividing circuit for dividing the frequency of an oscillation signal supplied thereto and outputting a plurality of divided-frequency signals having frequencies different from each other; and
a plurality of mixer circuits each used for being inputted one of said divided-frequency signals output by said frequency dividing circuits and one of received signals having selection bands different from each other, converting the frequency of said received signal and outputting said received signal with said converted frequency as an intermediate-frequency signal,
wherein:
a specific one of said mixer circuits corresponding to a selected reception band is put in an operating state and said intermediate-frequency signal generated by said specific mixer circuit is output; and
by changing the frequency of said local oscillation signal for said selected reception band, said frequency of said received signal is changed.

9. The reception IC according to claim 8 wherein:
each of said mixer circuits has a multiplier for multiplying said received signal supplied thereto by one of said divided-frequency signals supplied thereto and is put in an operating state by superimposing a control signal on said received signal supplied to said multiplier.

10. The reception IC according to claim 8 wherein:
every pair of said mixer circuits are assigned to each of said received signals; and
a divided-frequency signal supplied to any of said pairs comprises 2 signal components with phases shifted from each other by 90 degrees respectively supplied to said mixer circuits composing said pair to generate 2 intermediate-frequency signals with phases shifted from each other by 90 degrees.

11. The reception IC according to claim 8 wherein:
said reception bands are a low band and a high band of VHF television broadcasting; and
said divided-frequency signal used as a local oscillation signal in reception of a broadcast of said low band has a frequency equal to half a frequency of said divided-frequency signal used as a local oscillation signal in reception of a broadcast of said high band.

12. The reception IC according to claim 11 wherein a band of FM broadcasting is included in said low band.

13. A receiving apparatus including:
a reception IC comprising:
a received-signal-selecting circuit for selecting one of a plurality of received signals with reception bands different from each other;
a frequency dividing circuit for dividing the frequency of an oscillation signal supplied thereto and outputting a plurality of divided-frequency signals having frequencies different from each other;
a divided-frequency-signal-selecting circuit for selecting one of said divided-frequency signals output by said frequency dividing circuit as a local-oscillation signal; and
a mixer circuit for being inputted said local-oscillation signal output by said divided-frequency-signal-selecting circuit and said received signal selected by said received-signal-selecting circuit, converting the frequency of said received signal and outputting said received signal with said converted frequency as an intermediate-frequency signal,
wherein:
said received-signal-selecting circuit selects one of said received signals for a selected reception band; said divided-frequency-signal-selecting circuit selects one of said divided-frequency signals for said selected reception band; and
by changing the frequency of said local oscillation signal for each selected reception band, said frequency of said received signal is changed, and
a circuit for processing said intermediate-frequency signal output by said reception IC and outputting an audio signal obtained as a result of processing.

14. The receiving apparatus according to claim 13 wherein the frequency of said intermediate-frequency signal is 0.

15. A receiving apparatus including:
a reception IC comprising:
a frequency dividing circuit for dividing the frequency of an oscillation signal supplied thereto and outputting a plurality of divided-frequency signals having frequencies different from each other; and
a plurality of mixer circuits each used for being inputted one of said divided-frequency signals output by said frequency dividing circuits and one of received signals having selection bands different from each other, converting the frequency of said received signal and outputting said received signal with said converted frequency as an intermediate-frequency signal,
wherein:
a specific one of said mixer circuits corresponding to a selected reception band is put in an operating state and said intermediate-frequency signal generated by said specific mixer circuit is output; and
by changing the frequency of said local oscillation signal for said selected reception band, said frequency of said received signal is changed, and
a circuit for processing said intermediate-frequency signal output by said reception IC and outputting an audio signal obtained as a result of processing.

16. The receiving apparatus according to claim 15 wherein the frequency of said intermediate-frequency signal is 0.
